# EUROPEAN PATENT APPLICATION

(11) **EP 4 848 927 A1**
(43) Date of publication of application: **02.12.2026**
(21) Application number: 26166819.8
(22) Date of filing: 23.03.2026
(51) Int. Cl.: H10B 43/40, H10B 43/10, H10D 62/10, H10D 62/13, H10D 89/10, H10B 43/27

(54) **THREE-DIMENSIONAL SEMICONDUCTOR MEMORY DEVICE AND ELECTRONIC SYSTEM INCLUDING THE SAME**

(30) Priority: 27.05.2025 KR 20250068981
(71) Applicant: Samsung Electronics Co., Ltd., Suwon-si, Gyeonggi-do 16677 (KR)
(72) Inventor: LEE, Sohyeon, 16677 Suwon-si (KR); PARK, Sejun, 16677 Suwon-si (KR); LEE, Se Hoon, 16677 Suwon-si (KR)
(74) Representative: Marks & Clerk LLP

(57) **Abstract**

A three-dimensional semiconductor memory device includes a peripheral circuit structure on a substrate and including a page buffer, and a cell array structure on the peripheral circuit structure and including a stack structure including interlayer insulating layers and gate electrodes alternately stacked along a first direction vertical to an upper surface of the substrate, and a bit line coupled with the page buffer. The page buffer includes an active pattern, a first gate pattern, and a second gate pattern. The first gate pattern and the second gate pattern cross the active pattern in a second direction parallel to the upper surface of the substrate, and are spaced apart from each other in a third direction crossing the second direction. The active pattern includes a first region extending along the third direction, and a second region extending along a fourth direction between the second direction and the third direction.

## Description

### BACKGROUND

### 1. Field

The present disclosure relates generally to semiconductor devices, and more particularly, to a three-dimensional semiconductor memory device and an electronic system including the same.

### 2. Description of Related Art

An electronic system may need data storage which may be provided by a semiconductor device that may be capable of storing a relatively large amount of data. Consequently, increases in integration levels of the semiconductor devices may be needed in order to attempt to provide for increasing demands for data storage capacity and to attempt to satisfy demands for improved performance and/or reductions in price from consumers of the semiconductor devices. Since a significant factor in determining an integration level of a two-dimensional semiconductor device or a planar semiconductor device may be an area occupied by a unit memory cell, the integration level of such a device may be significantly affected by a level of fine pattern-forming technology. However, relatively expensive apparatuses may be needed for forming fine patterns, and as such, the integration of the two-dimensional semiconductor device may be limited from increasing. Accordingly, three-dimensional semiconductor memory devices having memory cells three-dimensionally arranged may have been proposed.

### SUMMARY

One or more example embodiments of the present disclosure provide a three-dimensional semiconductor memory device with improved electrical characteristics and reliability, when compared to related semiconductor memory devices, and an electronic system including the same.

According to an aspect of the present disclosure, a three-dimensional semiconductor memory device includes a peripheral circuit structure on a substrate and including a page buffer, and a cell array structure on the peripheral circuit structure and including a stack structure including interlayer insulating layers and gate electrodes alternately stacked along a first direction vertical to an upper surface of the substrate, and a bit line coupled with the page buffer. The page buffer includes an active pattern, a first gate pattern, and a second gate pattern. The first gate pattern and the second gate pattern cross the active pattern in a second direction parallel to the upper surface of the substrate. The first gate pattern and the second gate pattern are spaced apart from each other in a third direction crossing the second direction. The active pattern includes a first region extending along the third direction, and a second region extending along a fourth direction between the second direction and the third direction.

According to an aspect of the present disclosure, a three-dimensional semiconductor memory device includes a peripheral circuit structure on a substrate and including a page buffer, and a cell array structure on the peripheral circuit structure and including a stack structure including interlayer insulating layers and gate electrodes alternately stacked along a first direction vertical to an upper surface of the substrate, and a bit line coupled with the page buffer. The page buffer includes an active pattern, a first gate pattern, and a second gate pattern. The first gate pattern and the second gate pattern cross the active pattern in a second direction parallel to the upper surface of the substrate. The first gate pattern and the second gate pattern are spaced apart from each other in a third direction crossing the second direction. The active pattern includes a first channel region at least partially vertically overlapping the first gate pattern, a second channel region at least partially vertically overlapping the second gate pattern, a first contact region and a second contact region spaced apart from each other with the first channel region therebetween, and a third contact region spaced apart from the first contact region with the second channel region therebetween. The first channel region, the second channel region, and at least one of the first contact region, the second contact region, or the third contact region extend along the third direction. Another region of the at least one of the first contact region, the second contact region, or the third contact region extends along a fourth direction between the second direction and the third direction.

According to an aspect of the present disclosure, an electronic system includes a three-dimensional semiconductor memory device, and a controller electrically coupled with the three-dimensional semiconductor memory device through an input-output pad, and configured to control the three-dimensional semiconductor memory device. The three-dimensional semiconductor memory device includes a peripheral circuit structure on a substrate and including a page buffer, and a cell array structure on the peripheral circuit structure and including a stack structure including interlayer insulating layers and gate electrodes alternately stacked along a first direction vertical to an upper surface of the substrate, and a bit line coupled with the page buffer. The page buffer includes an active pattern, a first gate pattern, and a second gate pattern. The first gate pattern and the second gate pattern cross the active pattern in a second direction parallel to the upper surface of the substrate. The first gate pattern and the second gate pattern are spaced apart from each other in a third direction crossing the second direction. The active pattern includes a first region extending along the third direction, and a second region extending along a fourth direction between the second direction and the third direction.

Additional aspects may be set forth in part in the description which follows and, in part, may be apparent from the description, and/or may be learned by practice of the presented embodiments.

At least some of the above and other features of the invention are set out in the claims.

### BRIEF DESCRIPTION OF DRAWINGS

The above and other aspects, features, and advantages of certain embodiments of the present disclosure may be more apparent from the following description taken in conjunction with the accompanying drawings, in which:
FIG. 1 is a diagram schematically illustrating an electronic system including a three-dimensional semiconductor memory device, according to some embodiments of the present disclosure;
FIG. 2 is a perspective view schematically illustrating an electronic system including a three-dimensional semiconductor memory device, according to some embodiments of the present disclosure;
FIGS. 3 and 4 are cross-sectional views taken along line I-I' of FIG. 2 of semiconductor packages including a three-dimensional semiconductor memory device, according to some embodiments of the present disclosure;
FIG. 5 is a perspective view schematically illustrating a three-dimensional semiconductor memory device, according to some embodiments of the present disclosure;
FIG. 6 is a perspective view schematically illustrating a three-dimensional semiconductor memory device, according to some embodiments of the present disclosure;
FIG. 7 is a cross-sectional view illustrating a three-dimensional semiconductor memory device, according to some embodiments of the present disclosure;
FIG. 8 is a perspective view schematically illustrating a page buffer of a three-dimensional semiconductor memory device, according to some embodiments of the present disclosure;
FIG. 9 is a diagram illustrating a circuit diagram of a transistor group of a transistor array of the page buffer of FIG. 8, according to some embodiments of the present disclosure;
FIG. 10 is a plan view illustrating the transistor array of the page buffer of FIG. 8, according to some embodiments of the present disclosure;
FIG. 11 is a cross-sectional view illustrating a cell array structure of a three-dimensional semiconductor memory device, according to some embodiments of the present disclosure;
FIG. 12 is a cross-sectional view illustrating a cell array structure of a three-dimensional semiconductor memory device, according to some embodiments of the present disclosure; and
FIGS. 13 to 20 are plan views illustrating some components of the transistor array of the page buffer of FIG. 8, according to some embodiments of the present disclosure.

### DETAILED DESCRIPTION

The following description with reference to the accompanying drawings is provided to assist in a comprehensive understanding of embodiments of the present disclosure defined by the claims and their equivalents. Various specific details are included to assist in understanding, but these details are considered to be examples only. Therefore, those of ordinary skill in the art may recognize that various changes and modifications of the embodiments described herein may be made without departing from the scope of the disclosure. In addition, descriptions of well-known functions and structures are omitted for clarity and conciseness.

With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wired), wirelessly, or via a third element.

It is to be understood that when an element or layer is referred to as being "over," "above," "on," "below," "under," "beneath," "connected to" or "coupled to" another element or layer, it may be directly over, above, on, below, under, beneath, connected or coupled to the other element or layer or intervening elements or layers may be present. In contrast, when an element is referred to as being "directly over," "directly above," "directly on," "directly below," "directly under," "directly beneath," "directly connected to" or "directly coupled to" another element or layer, there are no intervening elements or layers present. It will be understood that such directional terms are relative to a device, and do not imply any particular orientation of that device.

The terms "upper," "middle", "lower", or the like may be replaced with terms, such as "first," "second," third" to be used to describe relative positions of elements. The terms "first," "second," third" may be used to describe various elements but the elements are not limited by the terms and a "first element" may be referred to as a "second element". Alternatively or additionally, the terms "first", "second", "third", or the like may be used to distinguish components from each other and do not limit the present disclosure. For example, the terms "first", "second", "third", or the like may not necessarily involve an order or a numerical meaning of any form.

As used herein, when an element or layer is referred to as "covering", "overlapping", or "surrounding" another element or layer, the element or layer may cover at least a portion of the other element or layer, where the portion may include a fraction of the other element or may include an entirety of the other element. Similarly, when an element or layer is referred to as "penetrating" another element or layer, the element or layer may penetrate at least a portion of the other element or layer, where the portion may include a fraction of the other element or may include an entire dimension (e.g., length, width, depth) of the other element.

Reference throughout the present disclosure to "one embodiment," "an embodiment," "an example embodiment," or similar language may indicate that a particular feature, structure, or characteristic described in connection with the indicated embodiment is included in at least one embodiment of the present solution. Thus, the phrases "in one embodiment", "in an embodiment," "in an example embodiment," and similar language throughout this disclosure may, but do not necessarily, all refer to the same embodiment. The embodiments described herein are example embodiments, and thus, the disclosure is not limited thereto and may be realized in various other forms.

The embodiments herein may be described and illustrated in terms of blocks, as shown in the drawings, which carry out a described function or functions. These blocks, which may be referred to herein as units or modules or the like, or by names such as device, logic, circuit, controller, counter, comparator, generator, converter, or the like, may be physically implemented by analog and/or digital circuits including one or more of a logic gate, an integrated circuit, a microprocessor, a microcontroller, a memory circuit, a passive electronic component, an active electronic component, an optical component, and the like.

In the present disclosure, the articles "a" and "an" are intended to include one or more items, and may be used interchangeably with "one or more." Where only one item is intended, the term "one" or similar language is used. For example, the term "a processor" may refer to either a single processor or multiple processors. When a processor is described as carrying out an operation and the processor is referred to perform an additional operation, the multiple operations may be executed by either a single processor or any one or a combination of multiple processors.

As used herein, each of the terms "SiN", "SiO", "SiON", or the like may refer to a material made of elements included in each of the terms and is not a chemical formula representing a stoichiometric relationship.

Hereinafter, a three-dimensional semiconductor memory device and a method for manufacturing the same, according to various embodiments of the present disclosure, are described with reference to the drawings.

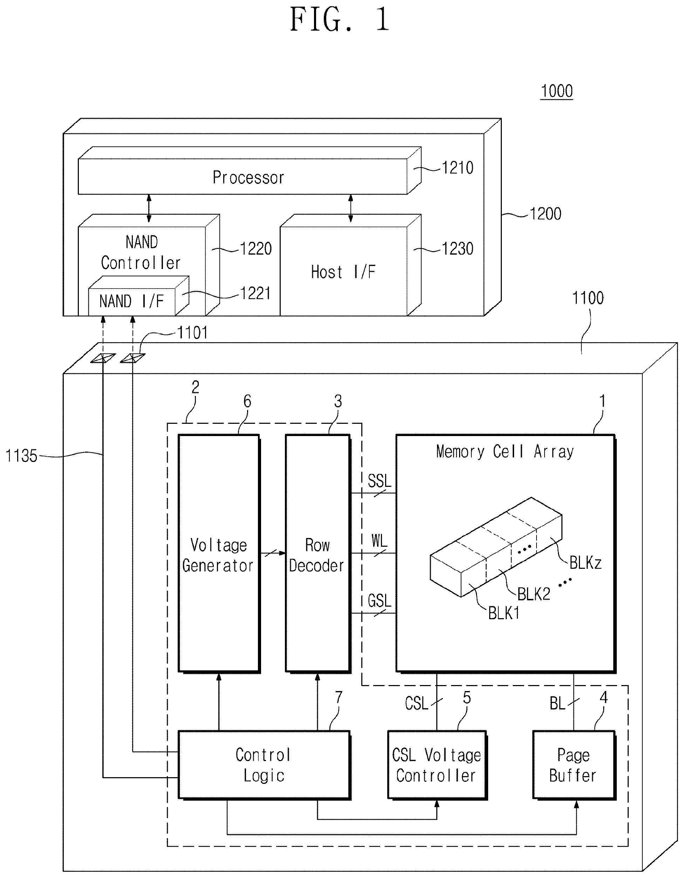

FIG. 1 is a diagram schematically illustrating an electronic system including a three-dimensional semiconductor memory device, according to some embodiments of the present disclosure.

Referring to FIG. 1, an electronic system 1000, according to some embodiments of the present disclosure, may include a three-dimensional semiconductor memory device 1100 and a controller 1200 electrically connected to the three-dimensional semiconductor memory device 1100. The electronic system 1000 may be and/or may include a storage device including one or a plurality of three-dimensional semiconductor memory devices 1100, and/or an electronic device including the storage device. For example, the electronic system 1000 may be and/or may include a solid state drive (SSD) device, a universal serial bus (USB), a computing system, a medical device, a communication device, or the like including the one or the plurality of three-dimensional semiconductor memory devices 1100.

The three-dimensional semiconductor memory device 1100 may be and/or may include a non-volatile memory device, such as, but not limited to, a NAND flash memory device.

The three-dimensional semiconductor memory device 1100 may include a memory cell array 1 and a peripheral circuit 2 that may control the memory cell array 1. The peripheral circuit 2 may include a row decoder 3, a page buffer 4, a common source line (CSL) voltage control circuit 5, a voltage generator 6, and control logic 7.

The memory cell array 1 may include a plurality of memory blocks (e.g., a first memory block BLK1 to a z-th memory block BLKz, where z is a positive integer greater than one (1)). Each memory block of the plurality of memory blocks BLK1 to BLKz may include three-dimensionally arranged memory cells. For example, each memory block of the plurality of memory blocks BLK1 to BLKz may include stacked structures. The plurality of memory blocks BLK1 to BLKz may read data from and/or may write data to a selected memory block in response to a corresponding block selection signal. An erase operation may be performed in memory cells of the memory cell array 1 in units of blocks (e.g., one or more blocks at a time).

For example, the three-dimensional semiconductor memory device 1100 may be and/or may include a vertical NAND flash memory device. In the vertical NAND flash memory device, the plurality of memory blocks BLK1 to BLKz may include a plurality of cell strings configured in a NAND type.

The row decoder 3 may decode an address input from the outside (e.g., the controller 1200) to select at least one block of the plurality of memory blocks BLK1 to BLKz, and may select word lines WL, a string selection line SSL, and a ground selection line GSL of a selected memory block. The row decoder 3 may transmit a voltage for performing a memory operation to the word line WL of the selected memory block.

The page buffer 4 may be connected to the memory cell array 1 through bit lines BL to read information stored in the memory cells.

The page buffer 4 may operate as a writing driver during program operation to apply, to the bit line BL, a voltage according to a data to be stored in the memory cell array 1, and may operate as a sense amplifier during reading operation to sense the data stored in the memory cell array 1. The page buffer 4 may operate according to a control signal provided by the control logic 7.

The common source line (CSL) voltage control circuit 5 may be connected to the memory cell array 1 through a common source line CSL. The common source line (CSL) voltage control circuit 5 may apply a common source voltage (e.g., a power voltage or a ground voltage) to the common source line CSL on the basis of controlling of the control logic 7.

The voltage generator 6 may generate voltages (e.g., a program voltage, a reading voltage, an erase voltage, a pass voltage, a verification voltage, or the like) necessary for an internal operation of the memory cell array 1, according to controlling of the control logic 7.

On the basis of a command signal, an address signal and a control signal, the control logic 7 may generate various control signals for programming a data in the memory cell array 1, reading a data from the memory cell array 1, and/or erasing the data stored in the memory cell array 1.

The three-dimensional semiconductor memory device 1100 may communicate with the controller 1200 through an input-output pad 1101 electrically connected to the control logic 7. The input-output pad 1101 may be electrically connected to the control logic 7 through an input-output connection line 1135.

The controller 1200 may include a processor 1210, a NAND controller 1220, and a host interface 1230. According to embodiments, the electronic system 1000 may include the plurality of three-dimensional semiconductor memory devices 1100, and the controller 1200 may control the plurality of three-dimensional semiconductor memory devices 1100.

The processor 1210 may control overall operations of the electronic system 1000 including the controller 1200. The processor 1210 may operate according to a predetermined firmware, and may access the three-dimensional semiconductor memory device 1100 by controlling the NAND controller 1220. The NAND controller 1220 may include a NAND interface 1221 that may process communication with the three-dimensional semiconductor memory device 1100. A control command for controlling the three-dimensional semiconductor memory device 1100, a data to be recorded in the memory cells of the three-dimensional semiconductor memory device 1100, a data to be read from the memory cells of the three-dimensional semiconductor memory device 1100, or the like may be transmitted through the NAND interface 1221. The host interface 1230 may supply a communication function between the electronic system 1000 and an external host. After receiving a control command from the external host through the host interface 1230, the processor 1210 may control the three-dimensional semiconductor memory device 1100 in response to the control command.

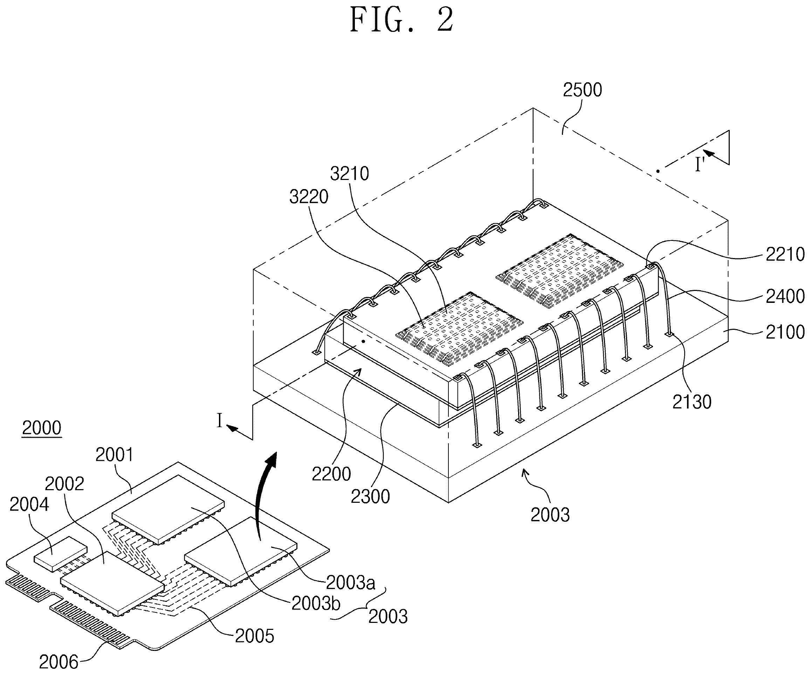

FIG. 2 is a perspective view schematically illustrating an electronic system including a three-dimensional semiconductor memory device, according to some embodiments of the present disclosure.

Referring to FIG. 2, an electronic system 2000, according to some embodiments of the present disclosure, may include a main substrate 2001, a controller 2002 mounted on the main substrate 2001, one or more semiconductor packages 2003, and a DRAM 2004. The semiconductor package 2003 and the DRAM 2004 may be connected to the controller 2002 by line patterns 2005 formed in the main substrate 2001.

The main substrate 2001 may include a connector 2006 including a plurality of pins coupled to an external host. A number and disposition of the plurality of pins in the connector 2006 may be changed according to a communication interface between the electronic system 2000 and the external host. For example, the electronic system 2000 may communicate with the external host according to one or more interfaces such as, but not limited to, a universal serial bus (USB), a peripheral component interconnect express (PCI-Express), a serial advanced technology attachment (SATA), and M-Phy for a universal flash storage (UFS). The electronic system 2000 may be operated by power supplied from the external host through the connector 2006. The electronic system 2000 may further include a power management integrated circuit (PMIC) that may distribute the power supplied from the external host to the controller 2002 and the semiconductor package 2003.

The controller 2002 may record (write) data to the semiconductor package 2003, and/or may read data from the semiconductor package 2003, and may improve an operation speed of the electronic system 2000, when compared to a related semiconductor package.

The DRAM 2004 may be and/or may include a buffer memory for alleviating a speed difference of the external host and the semiconductor package 2003, which may be a data storage space. The DRAM 2004 included in the electronic system 2000 may operate as a cache memory, and may provide a space for transiently storing a data in an operation of controlling the semiconductor package 2003. When the DRAM 2004 is included in the electronic system 2000, the controller 2002 may further include a DRAM controller for controlling the DRAM 2004, as well as, a NAND controller for controlling the semiconductor package 2003.

The semiconductor package 2003 may include a first semiconductor package 2003a and a second semiconductor package 2003b spaced apart from each other. Each of the first and second semiconductor packages 2003a and 2003b may be a semiconductor package including a plurality of semiconductor chips 2200. Each of the first and second semiconductor packages 2003a and 2003b may include a package substrate 2100, the semiconductor chips 2200 on the package substrate 2100, adhesive layers 2300 disposed on a lower surface of each of the semiconductor chips 2200, a connection structure 2400 electrically connecting the package substrate 2100 and the semiconductor chips 2200, and a molding layer 2500 covering the semiconductor chips 2200 and the connection structure 2400 on the package substrate 2100.

The package substrate 2100 may be and/or may include a print circuit board including upper pads 2130. Each of the semiconductor chips 2200 may include an input-output pad 2210. The input-output pad 2210 may correspond to the input-output pad 1101 of FIG. 1. Each of the semiconductor chips 2200 may include stack structures 3210 and vertical structures 3220. Each of the semiconductor chips 2200 may include the three-dimensional semiconductor memory device, according to embodiments of the present disclosure.

For example, the connection structure 2400 may be and/or may include a bonding wire electrically connecting the upper pads 2130 and the input-output pad 2210. Accordingly, in each of the first and second semiconductor packages 2003a and 2003b, the semiconductor chips 2200 may be electrically connected to each other in a bonding wire manner, and may be electrically connected to the upper pads 2130 of the package substrate 2100. For example, in each of the first and second semiconductor packages 2003a and 2003b, the semiconductor chips 2200 may be electrically connected to each other by the connection structure including a through silicon via (TSV), instead of the connection structure 2400 of the bonding wire manner.

For example, the controller 2002 and the semiconductor chips 2200 may be included in one package. For example, the controller 2002 and the semiconductor chips 2200 may be mounted on the main substrate 2001 and another separate interposer substrate, and may be connected to each other by a line formed in the interposer substrate.

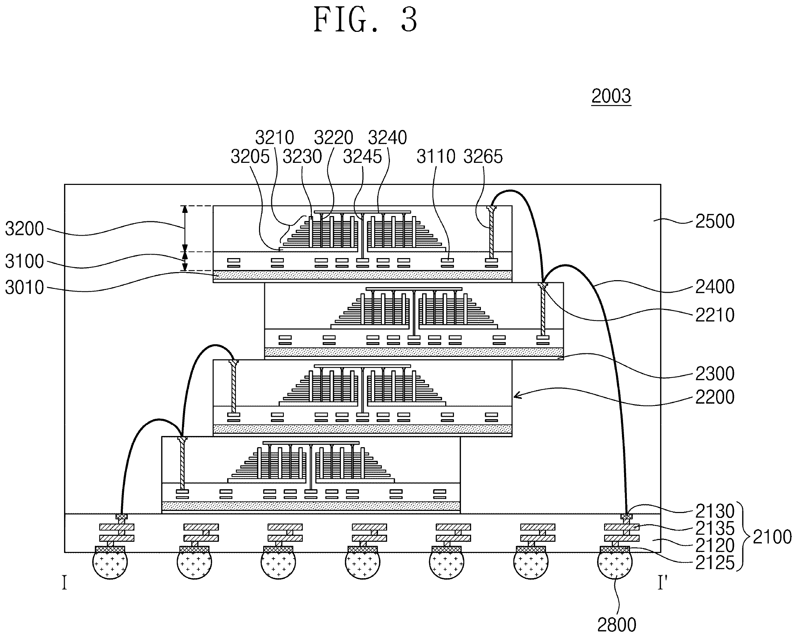

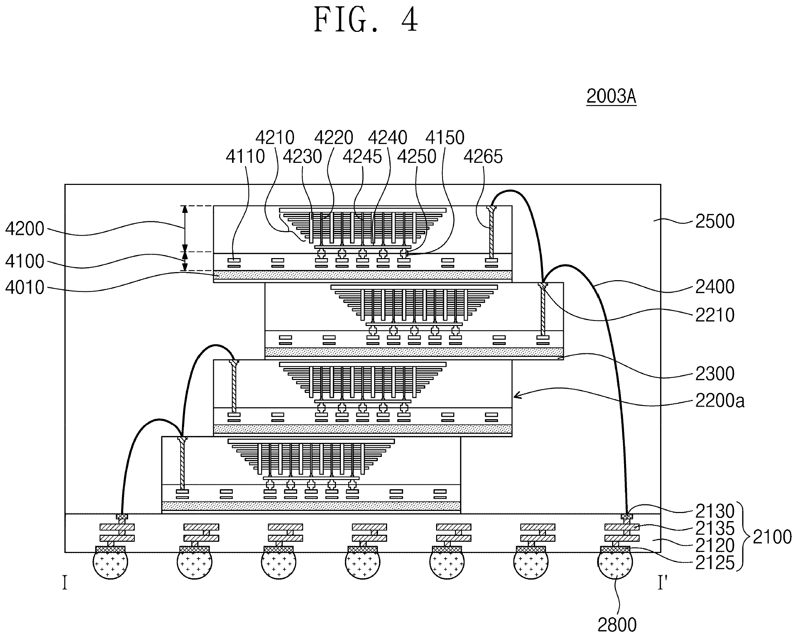

FIGS. 3 and 4 are cross-sectional views taken along line I-I' of FIG. 2 of semiconductor packages including a three-dimensional semiconductor memory device, according to some embodiments of the present disclosure.

Referring to FIGS. 3 and 4, the package substrate 2100 may be and/or may include a print circuit board in the semiconductor package 2003. The package substrate 2100 may include a package substrate body 2120, the upper pads 2130 disposed on an upper surface of the package substrate body 2120, lower pads 2125 disposed on a lower surface of the package substrate body 2120 or exposed through the lower surface of the package substrate body 2120, and internal lines 2135 electrically connecting the lower pads 2125 and the upper pads 2130 inside the package substrate body 2120. The upper pads 2130 may be electrically connected to the connection structures 2400. The lower pads 2125 may be connected to the line patterns 2005 of the main substrate 2001 of the electronic system 2000 through conductive connections 2800, as described above with reference to FIG. 2.

Referring to FIG. 3, each of the semiconductor chips 2200 may include a semiconductor substrate 3010, and a first structure 3100 and a second structure 3200 sequentially stacked on the semiconductor substrate 3010. The first structure 3100 may include a peripheral circuit region including peripheral lines 3110. The second structure 3200 may include a source structure 3205, a stack structure 3210 on the source structure 3205, vertical structures 3220 and separation structures 3230 penetrating the stack structure 3210, bit lines 3240 electrically connected to the vertical structures 3220, and cell contact plugs electrically connected to word lines WL of the stack structure 3210.

Although the stack structure 3210 is illustrated as having a step structure, embodiments of the present disclosure are not limited thereto. For example, the stack structure 3210 may not have the step structure, and a plurality of layers of the stack structure 3210 may have a substantially similar and/or the same length. As another example, the plurality of layers of the stack structure 3210 may have different lengths forming a different structure.

The semiconductor chips 2200 may each include a penetration line 3245 electrically connected to the peripheral lines 3110 of the first structure 3100 and extending into the second structure 3200. The penetration line 3245 may be disposed outside the stack structure 3210, and may be further disposed so as to penetrate the stack structure 3210. Each of the semiconductor chips 2200 may further include the input-output pad 2210 (as shown in FIG. 2) electrically connected to the peripheral lines 3110 of the first structure 3100.

Referring to FIG. 4, in the semiconductor package 2003A, each of the semiconductor chips 2200a may include a semiconductor substrate 4010, a first structure 4100 on the semiconductor substrate 4010, and a second structure 4200 bonded to the first structure 4100 on the first structure 4100 in a wafer-bonding manner.

The first structure 4100 may include a peripheral circuit region including a peripheral line 4110 and first adhesive structures 4150. The second structure 4200 may include a source structure 4205, a stack structure 4210 between the source structure 4205 and the first structure 4100, vertical structures 4220 and separation structures 4230 penetrating the stack structure 4210, second adhesive structures 4250 electrically connected to each of the word lines WL of the vertical structures 4220 and the stack structure 4210. For example, the second adhesive structures 4250 may be respectively electrically connected to the vertical structures 4220 and the word lines WL through the bit lines 4240 electrically connected to the vertical structures 4220, and through cell contact plugs electrically connected to the word lines. While being in contact with each other, the first adhesive structures 4150 of the first structure 4100 and the second adhesive structures 4250 of the second structure 4200 may be bonded to each other. For example, bonding parts of the first adhesive structures 4150 and the second adhesive structures 4250 may be formed of copper (Cu).

Although the stack structure 4210 is illustrated as having a step structure, embodiments of the present disclosure are not limited thereto. For example, the stack structure 4210 may not have the step structure, and a plurality of layers of the stack structure 4210 may have a substantially similar and/or the same length. As another example, the plurality of layers of the stack structure 4210 may have different lengths forming a different structure.

Each of the semiconductor chips 2200a may further include the input-output pad 2210 electrically connected to the peripheral lines 4110 of the first structure 4100.

The semiconductor chips 2200 of FIG. 3 and the semiconductor chips 2200a of FIG. 4 may be electrically connected to each other by the connection structures 2400 of the bonding wire form. However, for example, the semiconductor chips in one semiconductor package, such as the semiconductor chips 2200 of FIG. 3 and the semiconductor chips 2200a of FIG. 4, may be electrically connected to each other by a connection structure including the through silicon via (TSV).

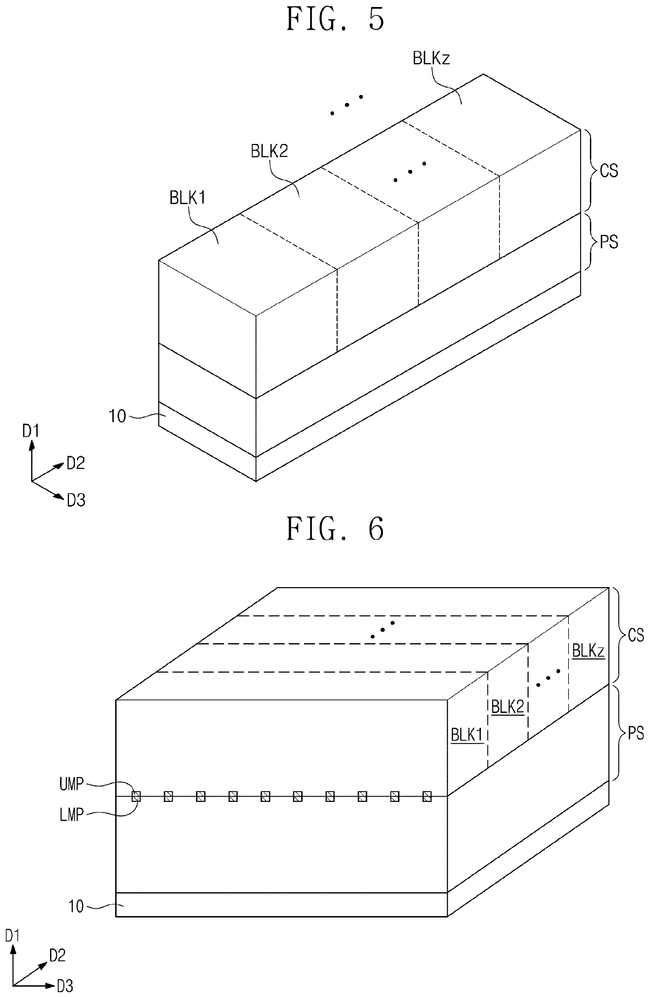

FIGS. 5 and 6 are respectively perspective views schematically illustrating a three-dimensional semiconductor memory device, according to some embodiments of the present disclosure.

Referring to FIGS. 5 and 6, the three-dimensional semiconductor memory device may include a substrate 10, a peripheral circuit structure PS on the substrate 10, and a cell array structure CS on the peripheral circuit structure PS.

The substrate 10 may be and/or may include the semiconductor substrate 3010 described with reference to FIG. 3 and/or the semiconductor substrate 4010 described with reference to FIG. 4. The peripheral circuit structure PS may be and/or may include the first structure 3100 described with reference to FIG. 3 and/or the first structure 4100 described with reference to FIG. 4. The cell array structure CS may be and/or may include the second structure 3200 described with reference to FIG. 3 and/or the second structure 4200 described with reference to FIG. 4.

The three-dimensional semiconductor memory device may include the substrate 10. For example, the substrate 10 may include a silicon (Si) substrate, a germanium (Ge) substrate, a silicon-germanium (SiGe) substrate, a single-crystalline epitaxial layer grown on a single-crystalline silicon substrate, or the like.

An upper surface of the substrate 10 may be vertical with respect to, e.g. perpendicular to, a first direction D1. The upper surface of the substrate 10 may be parallel to, e.g. in a plane defined by, each of a second direction D2 and a third direction D3 crossing each other. That is, the first direction D1 may be vertical to the upper surface of the substrate 10, and the second and third directions D2 and D3 may be parallel to the upper surface of the substrate 10. For example, the first, second and third directions D1, D2 and D3 may be directions perpendicular to each other. An element separation layer may be provided in the substrate 10, and may define an active region of the substrate 10. It will be understood that the directions D1, D2, D3 are relative to the memory device and do not imply any particular orientation thereof.

The peripheral circuit structure PS may be and/or may include the peripheral circuit 2 described with reference to FIG. 1. The cell array structure CS may include a plurality of memory blocks BLK1 to BLKz described with reference to FIG. 1. For example, the peripheral circuit structure PS may be interposed between the substrate 10 and the cell array structure CS. However, embodiments of the present disclosure are not limited thereto.

Referring to FIG. 5, the peripheral circuit structure PS may be electrically connected to the cell array structure CS through the penetration line 3245 described above with reference to FIG. 3.

Referring to FIG. 6, lower metal pads LMP may be provided on an upper portion of the peripheral circuit structure PS. The lower metal pads LMP may be and/or may include the first adhesive structures 4150 described with reference to FIG. 4. The lower metal pads LMP may be electrically connected to the peripheral circuit 2 of the peripheral circuit structure PS.

Upper metal pads UMP may be provided on a lower portion of the cell array structure CS. The upper metal pads UMP may be and/or may include the second adhesive structures 4250 described with reference to FIG. 4. The upper metal pads UMP may be electrically connected to the memory blocks BLK1 to BLKz in the cell array structure CS.

For example, the cell array structure CS and the peripheral circuit structure PS on the substrate 10 may be separately formed. Thereafter, the peripheral circuit structure PS and the cell array structure CS may be connected to each other in a bonding manner. For example, each of the lower metal pads LMP in the peripheral circuit structure PS may be in contact with each of the upper metal pads UMP in the cell array structure CS in the bonding manner, and thus, the peripheral circuit structure PS may be electrically connected to the cell array structure CS.

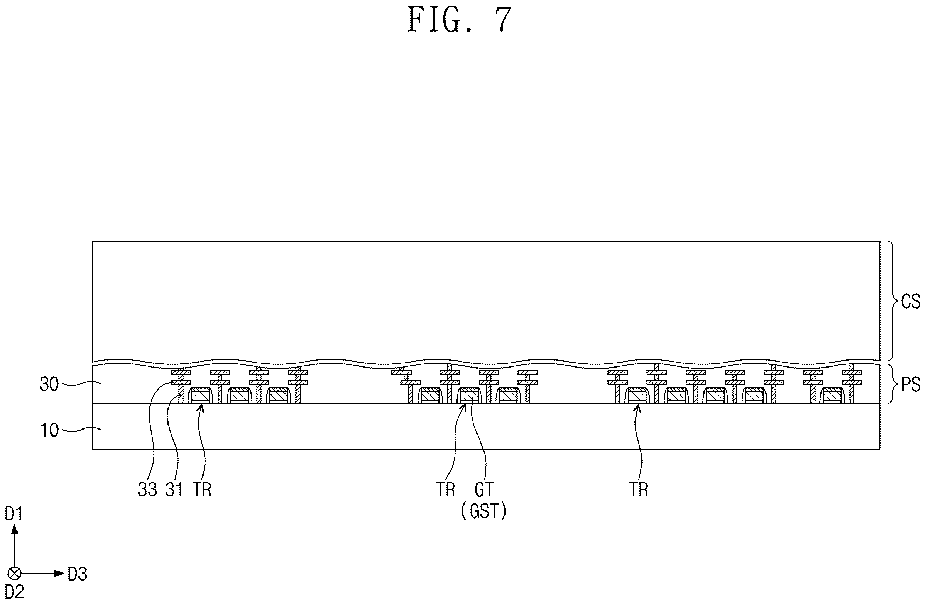

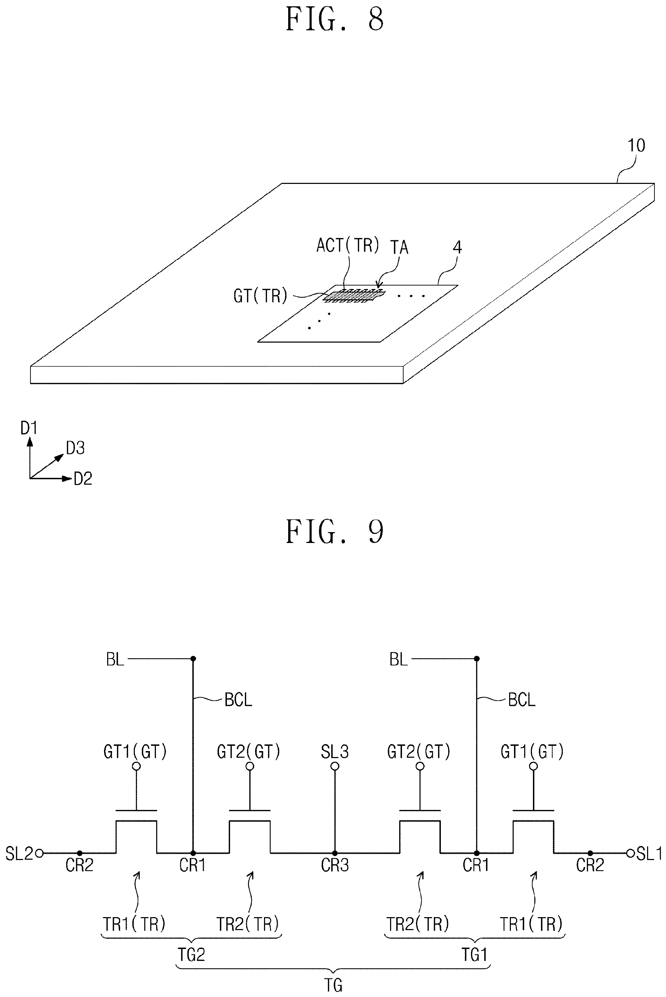

FIG. 7 is a cross-sectional view illustrating a three-dimensional semiconductor memory device, according to some embodiments of the present disclosure. FIG. 8 is a perspective view schematically illustrating the page buffer of a three-dimensional semiconductor memory device, according to some embodiments of the present disclosure. FIG. 9 is a diagram illustrating a circuit diagram of a transistor group TG of a transistor array TA of the page buffer 4 of FIG. 8, according to some embodiments of the present disclosure.

Referring to FIG. 7, the peripheral circuit structure PS may be provided on the substrate 10. The peripheral circuit structure PS may include transistors TR on the substrate 10, first contacts 31, first lines 33 electrically connected to the transistors TR through the first contacts 31, and a first insulating layer 30 covering the same. The peripheral circuit structure PS may include the peripheral circuit 2 described above with reference to FIG. 1. The transistors TR may be transistors that constitute the peripheral circuit 2.

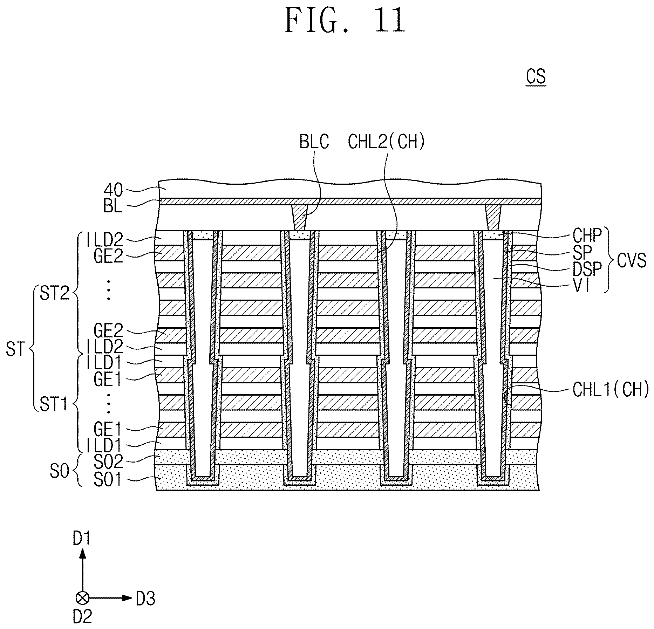

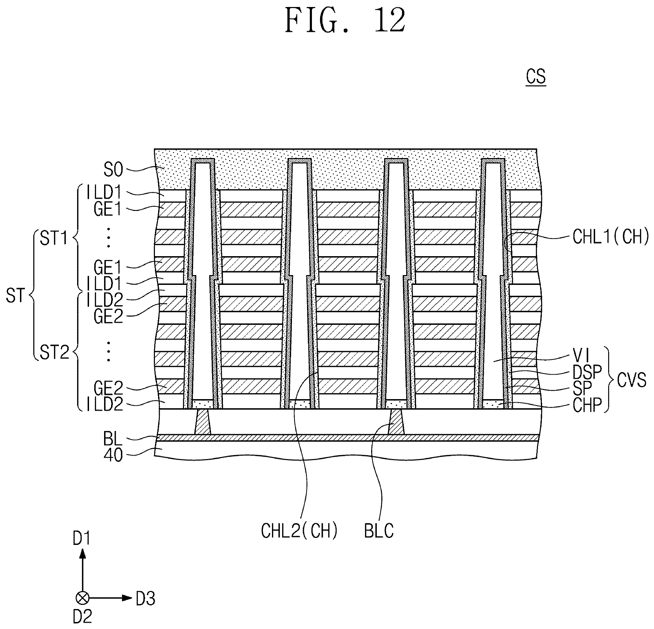

The cell array structure CS may be provided on the peripheral circuit structure PS. The cell array structure CS is further described with reference to FIGS. 11 and 12.

Referring to FIGS. 7 and 8, the peripheral circuit 2 of the peripheral circuit structure PS on the substrate 10 may include the page buffer 4. The page buffer 4 may include transistor arrays TA including a plurality of transistors TR. Each of the transistors TR of the transistor array TA may include an active pattern ACT and a gate structure GST crossing the active pattern ACT. For example, the active pattern ACT may be and/or may include a portion (e.g., a region, protruding in the first direction D1, of the substrate 10) of the substrate 10. The gate structure GST may include a gate pattern GT, a gate insulating pattern between the gate pattern GT and the active pattern ACT, and a spacer covering a capping pattern on an upper surface of the gate pattern GT and side surfaces of the gate pattern GT.

Referring to FIGS. 8 and 9, FIG. 9 illustrates a circuit diagram of one of the transistor groups TG of the transistor array TA of FIG. 8. The transistor group TG may be a set of the transistors TR sharing one active pattern ACT. The transistor group TG may include a first transistor group TG1 and a second transistor group TG2 sharing one active pattern ACT. For example, each of the first transistor group TG1 and the second transistor group TG2 may include a first transistor TR1 and a second transistor TR2.

The first transistor TR1 and the second transistor TR2 of the first transistor group TG1, and the first transistor TR1 and the second transistor TR2 of the second transistor group TG2 may each include a first contact region CR1. For example, the first contact region CR1 may be a drain region of each of the first transistor TR1 and the second transistor TR2. The first transistor TR1 and the second transistor TR2 may share the first contact region CR1.

The first transistor TR1 of the first transistor group TG1 and the first transistor TR1 of the second transistor group TG2 may each include a second contact region CR2. For example, the second contact region CR2 may be a source region of the first transistor TR1.

The second transistor TR2 of the first transistor group TG1 and the second transistor TR2 of the second transistor group TG2 may each include a third contact region CR3. For example, the third contact region CR3 may be a source region of the second transistor TR2. The second transistor TR2 of the first transistor group TG1 and the second transistor TR2 of the second transistor group TG2 may share the third contact region CR3.

Each of the transistors TR of the transistor group TG may include the gate pattern GT. The gate pattern GT may include a first gate pattern GT1 and a second gate pattern GT2. The first gate pattern GT1 may be the gate pattern GT of the first transistor TR1, and the second gate pattern GT2 may be the gate pattern GT of the second transistor TR2.

The second transistor TR2 of each of the first transistor group TG1 and the second transistor group TG2 may be interposed between the first transistor TR1 of the first transistor group TG1 and the first transistor TR1 of the second transistor group TG2.

Each of the first contact regions CR1 may correspond to a bit line node. The first transistor TR1 and the second transistor TR2 may share the bit line node. Each of the first contact regions CR1 may be connected to the bit lines BL in the cell array structure CS to be described later through a bit line conductive line BCL. For example, the bit line conductive line BCL may be composed of a plurality of contacts and a plurality of lines. That is, each of the first contact regions CR1 may be connected to the bit line BL through a plurality of conductive lines.

The second contact region CR2 of the first transistor TR1 of the first transistor group TG1 may be connected to a first source line SL1. A source voltage may be transmitted to the first transistor TR1 of the first transistor group TG1 through the first source line SL1. The second contact region CR2 of the first transistor TR1 of the second transistor group TG2 may be connected to a second source line SL2. The source voltage may be transmitted to the first transistor TR1 of the first transistor group TG1 through the second source line SL2.

The third contact region CR3 may be connected to a third source line SL3. The source voltage may be transmitted to each of the second transistor TR2 of the first transistor group TG1 and the second transistor TR2 of the second transistor group TG2 through the third source line SL3.

Although it is illustrated in the drawing that the transistor group TG is composed of the first transistor group TG1 and the second transistor group TG2, embodiments of the present disclosure are not limited thereto. For example, only one of the first transistor group TG1 and the second transistor group TG2 may be provided.

During a program operation of the three-dimensional semiconductor memory device, the first transistor TR1 may serve to transmit a specific voltage to the bit line BL in order to perform an operation of storing a data to a memory cell. Accordingly, during the program operation of the three-dimensional semiconductor memory device, the first transistor TR1 may be turned on, and the second transistor TR2 may be turned off.

During an erase operation of the three-dimensional semiconductor memory device, the second transistor TR2 may serve to transmit a specific voltage to the bit line BL in order to perform an operation of erasing a data stored in the memory cell. Accordingly, during the erase operation of the three-dimensional semiconductor memory device, the first transistor TR1 may be turned off, and the second transistor TR2 may be turned on.

In some embodiments of the present disclosure, the first transistor TR1 and the second transistor TR2 may share one bit line node. Accordingly, during a specific operation of the three-dimensional semiconductor memory device, when an off current flows from a transistor turned off, reliability of an operation of the three-dimensional semiconductor memory device may be degraded. For example, during the program operation of the three-dimensional semiconductor memory device, when the off current flows from the second transistor TR2, reliability of the program operation of the three-dimensional semiconductor memory device may be degraded. Similarly, during the erase operation of the three-dimensional semiconductor memory device, when the off current flows from the first transistor TR1, reliability of the erase operation of the three-dimensional semiconductor memory device may be degraded.

Accordingly, according to the present disclosure, during a specific operation of the three-dimensional semiconductor memory device, various transistor structures may be selected in order to reduce the off-current capable of being generated from the transistor turned off, and as further described below.

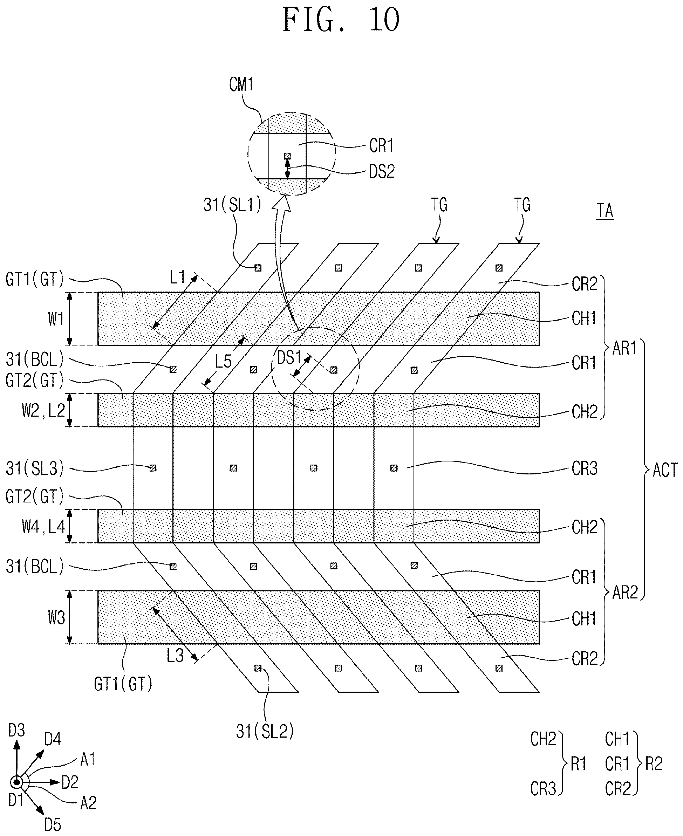

FIG. 10 is a plan view illustrating the transistor array TA of the page buffer of FIG. 8.

Referring to FIGS. 9 and 10, the transistor array TA may include a plurality of transistor groups TG disposed spaced apart from each other along the second direction D2. Each of the transistor groups TG may include the active pattern ACT and the gate pattern GT crossing the active pattern ACT in the second direction D2.

The gate pattern GT may include the first gate pattern GT1 and the second gate pattern GT2 disposed spaced apart from each other in the third direction D3 on the active pattern ACT. For example, the first gate pattern GT1 may include the first gate patterns GT1 (e.g., a pair of first gate patterns GT1) that may be spaced apart from each other in the third direction D3. As another example, the second gate pattern GT2 may include the second gate patterns GT2 (e.g., a pair of second gate patterns GT2) that may be spaced apart from each other in the third direction D3. The second gate patterns GT2 may be interposed between the first gate patterns GT1.

The active pattern ACT may include a first active region AR1, a second active region AR2 and the third contact region CR3 between the first active region AR1 and the second active region AR2. Each of the first active region AR1 and the second active region AR2 of the active pattern ACT may include a first channel region CH1 vertically overlapping the first gate pattern GT1, a second channel region CH2 vertically overlapping the second gate pattern GT2, the first contact region CR1 between the first channel region CH1 and the second channel region CH2, and the second contact region CR2 spaced apart from the first contact region CR1 with the first channel region CH1 therebetween.

The first active region AR1 and the third contact region CR3 may correspond to a region of the active pattern ACT of the first transistor group TG1. The second active region AR2 and the third contact region CR3 may correspond to a region of the active pattern ACT of the second transistor group TG2.

For example, the first to third contact regions CR1 to CR3 may include an impurity having an N-type or a P-type.

Some of the first contacts 31 described with reference to FIG. 7 may be connected to the first contact regions CR1. The first contacts 31 connected to the first contact regions CR1 may constitute a portion of the bit line conductive line BCL. Others of the first contacts 31 may be connected to the second contact regions CR2. The first contacts 31 connected to the second contact regions CR2 may constitute a portion of the first source line SL1 and a portion of the second source line SL2. Still others of the first contacts 31 may be connected to the third contact region CR3. The first contacts 31 connected to the third contact region CR3 may constitute a portion of the third source line SL3.

The active pattern ACT may include a first region R1 extending along the third direction D3 and a second region R2 extending along a direction forming an acute angle with the second direction D2. For example, the first region R1 of the active pattern ACT may extend in a form of a straight line, and the second region R2 may extend from the first region R1 in a form of a diagonal line.

The second channel region CH2 and the third contact region CR3 of each of the first active region AR1 and the second active region AR2 of the active pattern ACT may correspond to the first region R1 of the active pattern ACT. That is, a channel region and a source region of the second transistor TR2 may correspond to the first region R1 of the active pattern ACT.

The first channel region CH1, the first contact region CR1 and the second contact region CR2 of each of the first active region AR1 and the second active region AR2 of the active pattern ACT may correspond to the second region R2 of the active pattern ACT. That is, a channel region, a source region and a drain region of the first transistor TR1 may correspond to the second region R2 of the active pattern ACT.

For example, the first channel region CH1, the first contact region CR1 and the second contact region CR2 of the first active region AR1 may extend along a fourth direction D4. The fourth direction D4 may be a direction parallel to the upper surface of the substrate 10 (see FIG. 5), and may cross the second direction D2 and the third direction D3. The fourth direction D4 may be a direction between the second direction D2 and the third direction D3. The fourth direction D4 may form a first angle A1 with the second direction D2. The first angle A1 may be an acute angle (e.g., an angle between zero (0) degrees and ninety (90) degrees). Similarly, the fourth direction D4 may form an acute angle with the third direction D3.

The first channel region CH1, the first contact region CR1 and the second contact region CR2 of the second active region AR2 may extend along a fifth direction D5. The fifth direction D5 may be a direction parallel to the upper surface of the substrate 10, and may cross the second direction D2 and the third direction D3. The fifth direction D5 may be a direction between the second direction D2 and an opposite direction of the third direction D3. The fifth direction D5 may form a second angle A2 with the second direction D2. The second angle A2 may be an acute angle. Similarly, the fifth direction D5 may form an angle greater than ninety (90) and less than one hundred and eighty (180) degrees with the third direction D3.

With respect to the third direction D3, the first gate pattern GT1 crossing the first active region AR1 may have a first width W1. With respect to the third direction D3, the second gate pattern GT2 crossing the first active region AR1 may have a second width W2. With respect to the third direction D3, the first gate pattern GT1 crossing the second active region AR2 may have a third width W3. With respect to the third direction D3, the second gate pattern GT2 crossing the second active region AR2 may have a fourth width W4.

The first width W1 may be greater than the second width W2. The third width W3 may be greater than the fourth width W4.

The first channel region CH1 of the first active region AR1 may have a first length L1. The second channel region CH2 of the first active region AR1 may have a second length L2. The first channel region CH1 of the second active region AR2 may have a third length L3. The second channel region CH2 of the second active region AR2 may have a fourth length L4. The first contact region CR1 may have a fifth length L5.

The first channel region CH1 of the first active region AR1 may extend along the fourth direction D4 so that the first length L1 may be greater than the first width W1. The second channel region CH2 of the first active region AR1 may extend along the third direction D3 so that the second length L2 may be substantially similar and/or the same as the second width W2. The first channel region CH1 of the second active region AR2 may extend along the fifth direction D5 so that the third length L3 may be greater than the third width W3. The second channel region CH2 of the second active region AR2 may extend along the third direction D3 so that the fourth length L4 may be substantially similar and/or the same as the fourth width W4.

According to the present disclosure, the first channel region CH1 of the first transistor TR1 may extend along a direction forming an acute angle with an extension direction of the first gate pattern GT1. Accordingly, a length of the first channel region CH1 may be greater than a width of the first gate pattern GT1. As a result, a path of a current flowing to the channel region may become longer, and thus an off current generated by the first transistor TR1 may be reduced, when compared to related semiconductor memory devices.

According to the present disclosure, with respect to the fourth direction D4, a distance between the gate pattern GT and the first contact 31 of the bit line conductive line BCL on the first contact region CR1 may be a first distance DS1. According to a comparative example CM1 illustrated in FIG. 10, when the first contact region CR1 extends along the third direction D3, a distance between the gate pattern GT and the first contact 31 of the bit line conductive line BCL on the first contact region CR1 may be a second distance DS2. The first distance DS1 may be greater than the second distance DS2. The fifth length L5 may be greater than a distance between the first gate pattern GT1 and the second gate pattern GT2.

According to the present disclosure, the first contact region CR1 (e.g., the bit line node) shared by the first transistor TR1 and the second transistor TR2 may extend along a direction forming an acute angle with an extension direction of the gate pattern GT. Accordingly, with respect to a direction in which the first contact region CR1 extends, the first distance DS1 between the gate pattern GT and the first contact 31 on the first contact region CR1 may be greater than a distance in a case in which the first contact region CR1 extends along the third direction D3 perpendicular to the extension direction of the gate pattern GT. As a result, a path of a current from the channel region to the first contact 31 on the first contact region CR1 may become longer. Accordingly, the off current generated by the first transistor TR1 or the second transistor TR2 may be reduced, when compared to related semiconductor memory devices.

According to the present disclosure, the active pattern ACT having a partial region extending along a direction forming an acute angle with the second direction D2 may have a shorter length along the third direction D3 than the active pattern of which the overall region (i.e. all, or substantially all, of its length) extends along the third direction D3. Accordingly, a length of the transistor group TG may decrease, and integration of the transistor groups TG of the page buffer 4 may be improved, when compared to related semiconductor memory devices. As a result, integration of the three-dimensional semiconductor memory device may be improved, when compared to related semiconductor memory devices.

FIG. 11 is a cross-sectional view illustrating a cell array structure of a three-dimensional semiconductor memory device, according to some embodiments of the present disclosure.

Referring to FIG. 11, the cell array structure CS may be provided on the peripheral circuit structure PS (as shown in FIG. 7). The peripheral circuit structure PS may include and/or may be similar in many respects to the first structure 3100 of FIG. 3, and may include additional features not mentioned above. The cell array structure CS may include and/or may be similar in many respects to the second structure 3200 of FIG. 3, and may include additional features not mentioned above. Consequently, repeated descriptions of the cell array structure CS and the peripheral circuit structure PS described above with reference to FIG. 3 may be omitted for the sake of brevity.

The cell array structure CS may include a source layer SO, a stack structure ST on the source layer SO, a cell vertical structure CVS penetrating the stack structure ST, a second insulating layer 40 on the stack structure ST, a bit line BL in the second insulating layer 40, and a bit line contact BLC between the bit line BL and the cell vertical structure CVS.

For example, the source layer SO may include a first source layer SO1 and a second source layer SO2 on the first source layer SO1. As another example, each of the first source layer SO1 and the second source layer SO2 may include at least one of undoped polysilicon or doped polysilicon. The second source layer SO2 may be connected to a semiconductor pattern SP. The source layer SO may include and/or may be similar in many respects to the source structure 3205 as described with reference to FIG. 3, and may include additional features not mentioned above. Consequently, repeated descriptions of the source layer SO described above with reference to FIG. 3 may be omitted for the sake of brevity.

The stack structure ST may include a first stack structure ST1 on the source layer SO, and a second stack structure ST2 between the first stack structure ST1 and the second insulating layer 40. The first stack structure ST1 may include first interlayer insulating layers ILD1 and first gate electrodes GE1 alternately stacked, and the second stack structure ST2 may include second interlayer insulating layers ILD2 and second gate electrodes GE2 alternately stacked. The stack structure ST may include and/or may be similar in many respects to the stack structure 3210 described with reference to FIG. 3, and may include additional features not mentioned above. Consequently, repeated descriptions of the stack structure ST described above with reference to FIG. 3 may be omitted for the sake of brevity.

Channel holes CH may penetrate the stack structure ST in the first direction D1. The channel hole CH may include a first channel hole CHL1 penetrating the first stack structure ST1, and a second channel hole CHL2 penetrating the second stack structure ST2. For example, each of the first and second channel holes CHL1 and CHL2 may have a smaller width in the second direction D2 and/or the third direction D3 in a downward direction.

The cell vertical structures CVS may be provided in the channel holes CH. The cell vertical structure CVS may extend along the first direction D1, and may penetrate the stack structure ST. The cell vertical structure CVS may include a data storage pattern DSP and the semiconductor pattern SP sequentially covering a sidewall of the channel hole CH, a channel pad CHP between the semiconductor pattern SP and the bit line contact BLC, and an internal insulating layer VI filling a remaining portion of the channel hole CH.

For example, the semiconductor pattern SP may include a semiconductor material doped with an impurity, an intrinsic semiconductor material undoped with an impurity, a polycrystalline semiconductor material, or the like.

The data storage pattern DSP may include a blocking insulating layer, a charge storage layer, and a tunneling insulating layer sequentially provided on an internal sidewall of the channel hole CH.

The data storage pattern DSP may store and/or change a data by using a Fowler-Nordheim tunneling phenomenon induced by a voltage difference between the first and second gate electrodes GE1 and GE2 and the semiconductor pattern SP. For example, the blocking insulating layer and the tunneling insulating layer may include, for example, silicon oxide (SiO), and the charge storage layer may include at least one of silicon nitride (SiN), silicon oxynitride (SiON), or the like.

The bit line BL may be connected to the first contact region CR1 in the transistor group TG of the page buffer 4 through the bit line conductive line BCL.

A method for manufacturing a three-dimensional semiconductor memory device is described with reference to FIGS. 7 and 11. The substrate 10 may be prepared. An element separation layer defining an active region may be formed on the substrate 10.

The peripheral circuit structure PS may be formed on the substrate 10. Forming the peripheral circuit structure PS may include forming the transistors TR on the substrate 10, forming the first lines 33 and the first contacts 31 connected to the transistors TR, and forming the first insulating layer 30 covering the same.

For example, forming the transistors TR may include forming mask patterns on the substrate 10, forming the active pattern ACT by partially removing an upper portion of the substrate 10 using the mask patterns as masks, and forming the gate structure GST on the active pattern ACT. A form of the active pattern ACT may be substantially similar and/or the same as the form described with reference to FIG. 10.

The cell array structure CS may be formed on the peripheral circuit structure PS. Forming the cell array structure CS may include forming the source layer SO on the first insulating layer 30, forming, on the source layer SO, the stack structure ST including the gate electrodes GE1 and GE2 and the interlayer insulating layers ILD1 and ILD2 alternately disposed along the first direction D1, forming the cell vertical structure CVS penetrating the stack structure ST, forming the bit line contact BLC on the channel pad CHP of the cell vertical structure CVS, forming the bit line BL on the bit line contact BLC, and forming the second insulating layer 40 covering the same.

FIG. 12 is a cross-sectional view illustrating a cell array structure of a three-dimensional semiconductor memory device, according to some embodiments of the present disclosure.

Referring to FIG. 12, the peripheral circuit structure PS may include and/or may be similar in many respects to the first structure 4100 of FIG. 4, and may include additional features not mentioned above. Furthermore, the cell array structure CS may include and/or may be similar in many respects to the second structure 4200 of FIG. 4, and may include additional features not mentioned above. Consequently, repeated descriptions of the peripheral circuit structure PS and the cell array structure CS described above with reference to FIG. 4 may be omitted for the sake of brevity.

The second insulating layer 40 may be provided on the peripheral circuit structure PS. The stack structure ST may be provided on the second insulating layer 40. The source layer SO may be provided on the stack structure ST. The stack structure ST may include the first stack structure ST1, and the second stack structure ST2 between the first stack structure ST1 and the second insulating layer 40. The stack structure ST may correspond to the stack structure 4210 described with reference to FIG. 4.

For example, each of the first and second channel holes CHL1 and CHL2 may have a smaller width in the second direction D2 and/or the third direction D3 in an upward direction.

An upper portion of the semiconductor pattern SP may be exposed to the outside, and may be covered by the source layer SO. Accordingly, the source layer SO and the semiconductor pattern SP may be connected to each other. The source layer SO may correspond to the source structure 4205 described with reference to FIG. 4.

The method for manufacturing a three-dimensional semiconductor memory device is described with reference to FIGS. 7 and 12. The method for forming the peripheral circuit structure PS may include and/or may be the similar in many respects to the method described with reference to FIGS. 7 and 11, and may include additional features not mentioned above. For example, the lower metal pads LMP connected to the transistors TR through the first contacts 31 and the first lines 33 may be formed on an upper portion of the peripheral circuit structure PS. Consequently, repeated descriptions of the method described above with reference to FIGS. 7 and 11 may be omitted for the sake of brevity.

The cell array structure CS may be formed on a carrier substrate. Forming the cell array structure CS may include forming, on the carrier substrate, the stack structure ST including the interlayer insulating layers ILD1 and ILD2 and the gate electrodes GE1 and GE2 alternately disposed along the first direction D1, forming the cell vertical structure CVS penetrating the stack structure ST, forming the bit line contact BLC on the channel pad CHP of the cell vertical structure CVS, forming the bit line BL on the bit line contact BLC, forming the second insulating layer 40 covering the same, and forming the upper metal pads UMP on an upper portion of the second insulating layer 40.

Thereafter, the lower metal pads LMP of the peripheral circuit structure PS and the upper metal pads UMP of the cell array structure CS may be in contact with each other, and thus the peripheral circuit structure PS and the cell array structure CS may be bonded to each other.

Thereafter, the carrier substrate may be removed, and an upper portion of the semiconductor pattern SP may be exposed to the outside. The source layer SO may be formed on the stack structure ST.

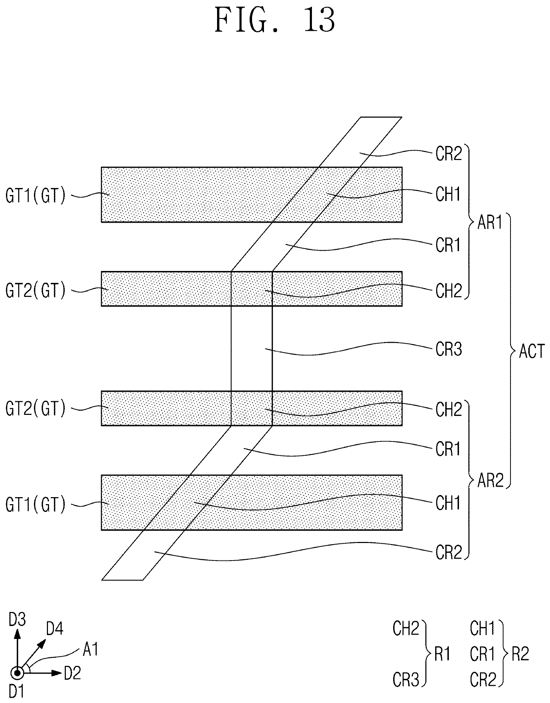

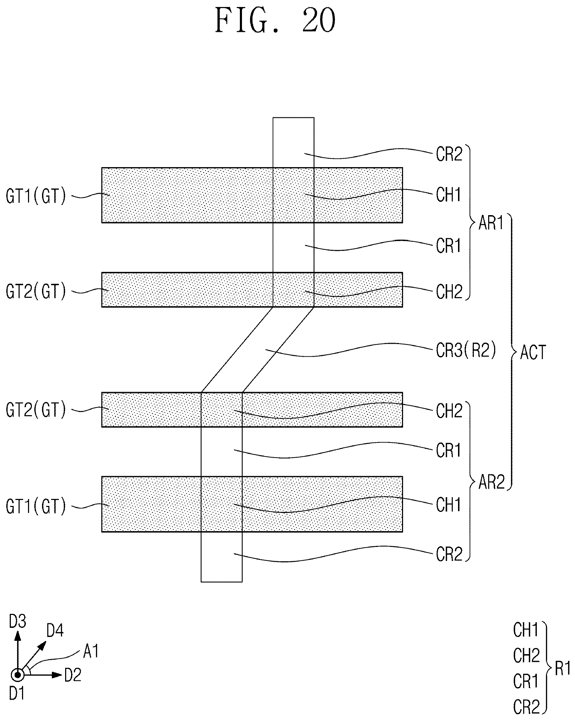

Hereinafter, the three-dimensional semiconductor memory device, according to embodiments of the present disclosure, is described with reference to FIGS. 13 and 20. For simplification of description, duplicate description of that described above will be omitted, and a difference from that described above will be mainly described. The three-dimensional semiconductor memory device described with reference to FIGS. 13 and 20 may include and/or may be similar in many respects to the three-dimensional semiconductor memory device described above with reference to FIGS. 1 to 12, and may include additional features not mentioned above. Consequently, repeated descriptions of the three-dimensional semiconductor memory device described above with reference to FIGS. 1 to 12 may be omitted for the sake of brevity.

FIG. 13 is a plan view illustrating some components of the transistor array TA of the page buffer 4 of FIG. 8.

Referring to FIG. 13, the first region R1 and the second region R2 of the active pattern ACT may be substantially similar and/or the same as the first region R1 and the second region R2 of the active pattern ACT described with reference to FIG. 10.

When the second direction D2 is defined as an x-axis direction, and the third direction D3 is defined as a y-axis direction, the first channel region CH1, the first contact region CR1 and the second contact region CR2 of the second active region AR2 may be symmetric about the origin with the first channel region CH1, the first contact region CR1 and the second contact region CR2 of the first active region AR1. That is to say, the first channel region CH1, the first contact region CR1 and the second contact region CR2 of the first active region AR1 and of the second active region AR2 may all extend in the fourth direction D4.

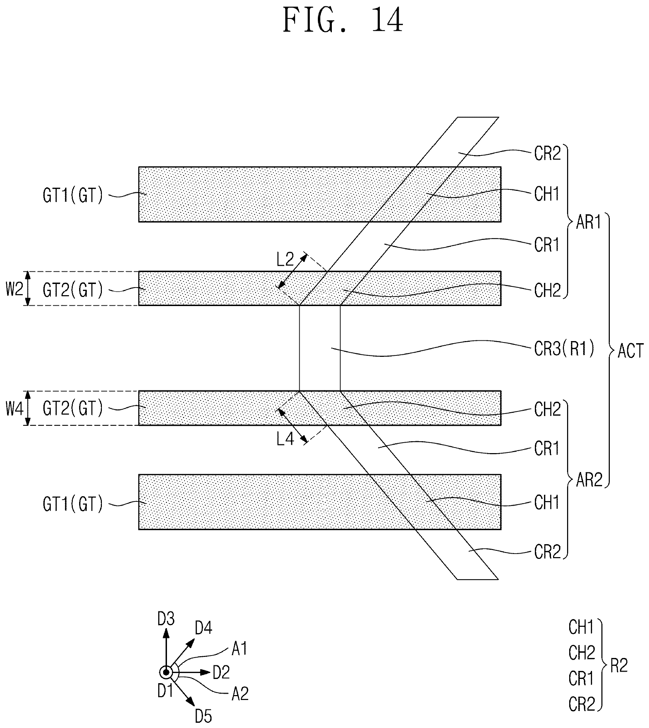

FIG. 14 is a plan view illustrating some components of the transistor array TA of the page buffer 4 of FIG. 8.

Referring to FIG. 14, the active pattern ACT may include the first region R1 extending along the third direction D3 and the second region R2 extending along a direction forming an acute angle with the second direction D2.

In some embodiments, the second channel region CH2 of each of the first active region AR1 and the second active region AR2 (i.e. all components thereof CR1, CR2, CH1, CH2) may correspond to the second region R2 of the active pattern ACT. For example, the second channel region CH2 of the first active region AR1 may extend along the fourth direction D4, and the second channel region CH2 of the second active region AR2 may extend along the fifth direction D5.

The second length L2 may be greater than the second width W2, and the fourth length L4 may be greater than the fourth width W4. Accordingly, a path of a current flowing to a channel region may become longer. Accordingly, the off current generated by the second transistor TR2 may be reduced, when compared to related semiconductor memory devices.

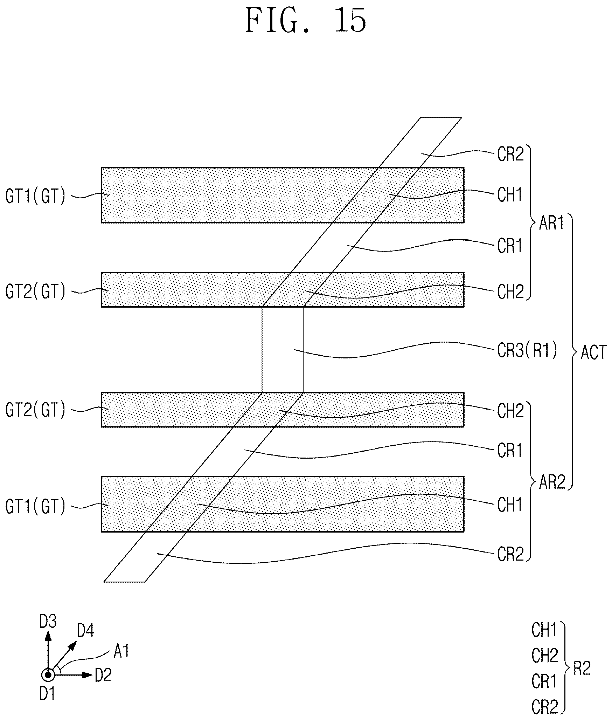

FIG. 15 is a plan view illustrating some components of the transistor array TA of the page buffer 4 of FIG. 8.

Referring to FIG. 15, the first region R1 and the second region R2 of the active pattern ACT may be substantially similar and/or the same as the first region R1 and the second region R2 of the active pattern ACT described with reference to FIG. 14.

When the second direction D2 is defined as an x-axis direction, and the third direction D3 is defined as a y-axis direction, the second active region AR2 may be symmetric about the origin with the first active region AR1. That is, all components CR1, CR2, CH1, CH2 of both active regions AR1, AR2 may extend along the fourth direction D4.

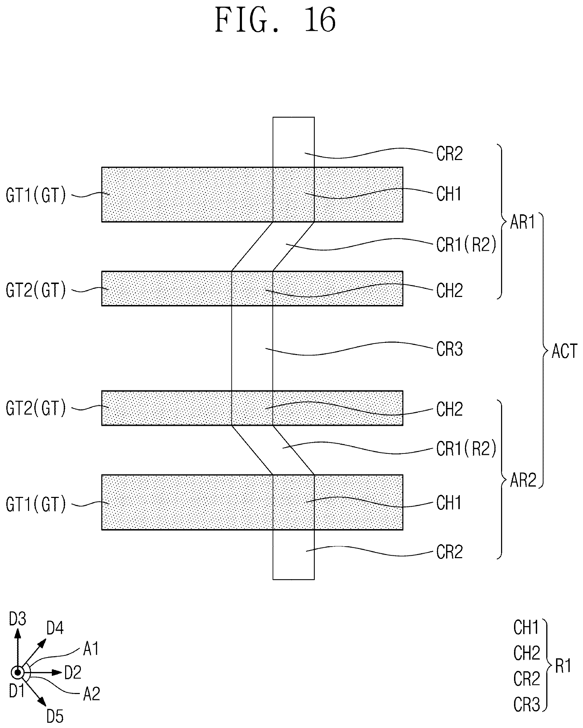

FIG. 16 is a plan view illustrating some components of the transistor array TA of the page buffer 4 of FIG. 8.

Referring to FIG. 16, the active pattern ACT may include the first region R1 extending along the third direction D3 and the second region R2 extending along a direction forming an acute angle with the second direction D2.

Regions, except for the first contact regions CR1, of the active pattern ACT may correspond to the first region R1 of the active pattern ACT. The first contact regions CR1 of the active pattern ACT may correspond to the second region R2 of the active pattern ACT. For example, the first contact region CR1 of the first active region AR1 may extend along the fourth direction D4. The first contact region CR1 of the second active region AR2 may extend along the fifth direction D5. Other components CH1, CH2, CR2 of the active regions may extend along the third direction D3.

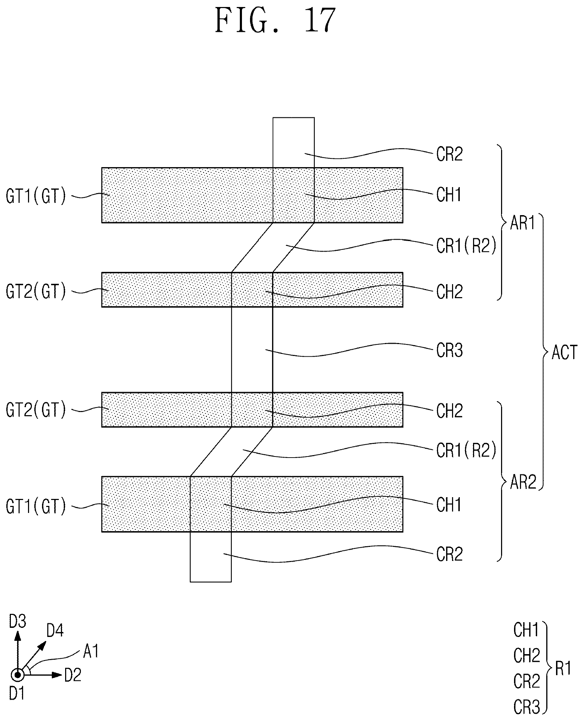

FIG. 17 is a plan view illustrating some components of the transistor array TA of the page buffer 4 of FIG. 8.

Referring to FIG. 17, the first region R1 and the second region R2 of the active pattern ACT may be substantially similar and/or the same as the first region R1 and the second region R2 of the active pattern ACT described with reference to FIG. 16.

When the second direction D2 is defined as an x-axis direction, and the third direction D3 is defined as a y-axis direction, the first channel region CH1, the first contact region CR1 and the second contact region CR2 of the second active region AR2 may be symmetric about the origin with the first channel region CH1, the first contact region CR1 and the second contact region CR2 of the first active region AR1.That is, the first contact regions CR1 may extend along the fourth direction D4, whilst the other components CH1, CH2, CR2 of the active regions may extend along the third direction D3.

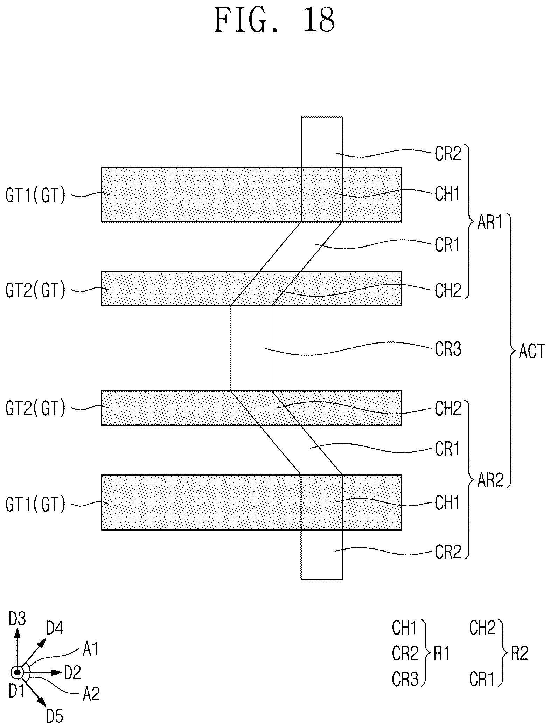

FIG. 18 is a plan view illustrating some components of the transistor array TA of the page buffer 4 of FIG. 8.

Referring to FIG. 18, the active pattern ACT may include the first region R1 extending along the third direction D3 and the second region R2 extending along a direction forming an acute angle with the second direction D2.

The first channel region CH1 and the second contact region CR2 of each of the first active region AR1 and the second active region AR2, and the third contact region CR3 of the active pattern ACT may correspond to the first region R1 of the active pattern ACT. The second channel region CH2 and the first contact region CR1 of each of the first active region AR1 and the second active region AR2 may correspond to the second region R2 of the active pattern ACT. For example, the first contact region CR1 and the second channel region CH2 of the first active region AR1 may extend along the fourth direction D4. The first contact region CR1 and the second channel region CH2 of the second active region AR2 may extend along the fifth direction D5. The first, second and third contact regions CR1, CR2, CR3 may extend along the third direction D3.

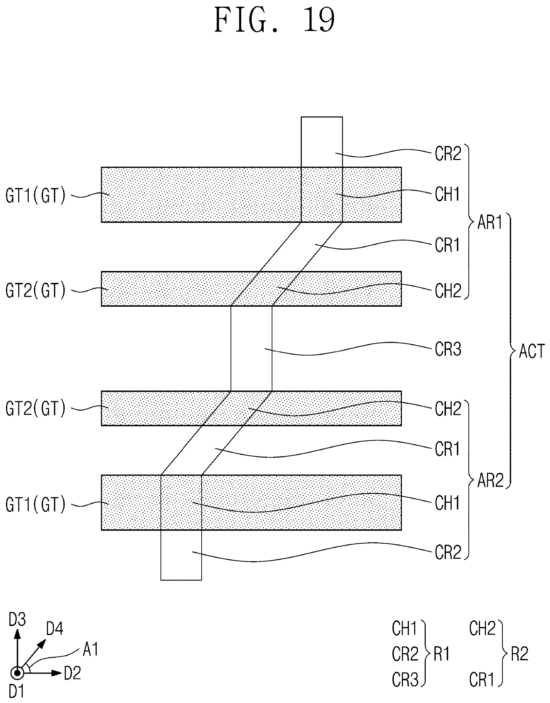

FIG. 19 is a plan view illustrating some components of the transistor array TA of the page buffer 4 of FIG. 8.

Referring to FIG. 19, the first region R1 and the second region R2 of the active pattern ACT may be substantially similar and/or the same as the first region R1 and the second region R2 of the active pattern ACT described with reference to FIG. 18.

When the second direction D2 is defined as an x-axis direction, and the third direction D3 is defined as a y-axis direction, the second active region AR2 may be symmetric about the origin with the first active region AR1. That is, the first contact regions CR1 and second channel regions CH2 may extend along the fourth direction D4, whilst the second contact regions CR2 and third contact region CR3 extends along the third direction DR3.

FIG. 20 is a plan view illustrating some components of the transistor array TA of the page buffer 4 of FIG. 8.

Referring to FIG. 20, the active pattern ACT may include the first region R1 extending along the third direction D3 and the second region R2 extending along a direction forming an acute angle with the second direction D2.

The third contact region CR3 of the active pattern ACT may correspond to the second region R2 of the active pattern ACT. The remaining region of the active pattern ACT may correspond to the first region R1 of the active pattern ACT.

When the second direction D2 is defined as an x-axis direction, and the third direction D3 is defined as a y-axis direction, the second active region AR2 may be symmetric about the origin with the first active region AR1. That is, the third contact region CR3 may extend along the fourth direction D4, whilst the first contact regions CR1, second contact regions CR2, first channel regions CH1 and second channel regions CH2 extend along the third direction D3.

According to the present disclosure, a channel region of a transistor may extend along a direction forming an acute angle with an extension direction of a gate pattern. Accordingly, a length of the channel region may be greater than a width of the gate pattern. As a result, a path of a current flowing to the channel region may become longer, and thus an off current generated by the transistor may be reduced, when compared to related semiconductor memory devices.

According to the present disclosure, a distance between the gate pattern and a conductive contact on a bit line node of the transistor in a case in which the bit line node of the transistor extends in a diagonal line may be greater than a distance between the gate pattern and a conductive contact on a bit line node of the transistor in a case in which the bit line node of the transistor extends in a straight line (e.g., a direction perpendicular to the extension direction of the gate pattern). Accordingly, a path of a current from the channel region to the conductive contact on the bit line node may become longer. As a result, an off current generated by the transistor may be reduced, when compared to related semiconductor memory devices.

According to the present disclosure, an active pattern having a partial region extending along a direction forming an acute angle with the extension direction of the gate pattern may have a shorter length along a Y-axis than the active pattern of which the overall region extends along a direction perpendicular to the extension direction of the gate pattern. Accordingly, a length of a transistor group may decrease, and integration of the transistor groups of a page buffer may be improved. As a result, integration of a three-dimensional semiconductor memory device may be improved, when compared to related semiconductor memory devices.

In an embodiment of the inventive concept, a method for manufacturing a three-dimensional semiconductor memory device includes forming a peripheral circuit structure including a page buffer and on a substrate, and forming a stack structure including interlayer insulating layers and gate electrodes alternately stacked along a first direction vertical to an upper surface of the substrate, and a cell array structure including a bit line, wherein the page buffer includes an active pattern, and a first gate pattern and a second gate pattern each crossing the active pattern in a second direction parallel to the upper surface of the substrate, and disposed spaced apart from each other in a third direction crossing the second direction, forming the active pattern includes forming mask patterns on the substrate, and forming the active pattern including a first region extending along the third direction and a second region extending along a fourth direction between the second direction and the third direction by partially removing an upper portion of the substrate using the mask patterns as masks, and the page buffer is connected to the bit line.

In an embodiment, the fourth direction may form an acute angle with the second direction.

In an embodiment, the second direction and the third direction may be perpendicular to each other.

In an embodiment, with respect to the third direction, the first gate pattern may have a greater width than the second gate pattern.

In an embodiment, the forming of the cell array structure may further include forming a cell vertical structure penetrating the stack structure, and the cell vertical structure may be connected to the page buffer through the bit line.

In an embodiment, the active pattern may include a first channel region vertically overlapping the first gate pattern, a second channel region vertically overlapping the second gate pattern, a first contact region and a second contact region spaced apart from each other with the first channel region therebetween, and a third contact region spaced apart from the first contact region with the second channel region therebetween.

In an embodiment, at least one of the first to third contact regions and the first and second channel regions of the active pattern may correspond to the second region of the active pattern.

In an embodiment, the first channel region of the active pattern may correspond to the second region of the active pattern, and a length of the first channel region may be greater than a width according to the third direction of the first gate pattern.

In an embodiment, the second channel region of the active pattern may correspond to the second region of the active pattern, and a length of the second channel region may be greater than a width according to the third direction of the second gate pattern.

In an embodiment, the first contact region of the active pattern may correspond to the second region of the active pattern, and a length of the first contact region may be greater than a distance between the first gate pattern and the second gate pattern.

The above description of embodiments of the present disclosure provides an example for description of the present disclosure. Therefore, the present disclosure is not limited to the above embodiments, and it may be apparent that various modifications and changes such as combining the above embodiments may be made by those skilled in the art.

Embodiments are set out in the following clauses:
1. A three-dimensional semiconductor memory device, comprising:
   a peripheral circuit structure on a substrate and comprising a page buffer; and
   a cell array structure on the peripheral circuit structure and comprising a stack structure comprising:
      interlayer insulating layers and gate electrodes alternately stacked along a first direction vertical to an upper surface of the substrate; and
      a bit line coupled with the page buffer,
   wherein the page buffer comprises an active pattern, a first gate pattern, and a second gate pattern,
   wherein the first gate pattern and the second gate pattern cross the active pattern in a second direction parallel to the upper surface of the substrate,
   wherein the first gate pattern and the second gate pattern are spaced apart from each other in a third direction crossing the second direction, and
   wherein the active pattern comprises:
      a first region extending along the third direction; and
      a second region extending along a fourth direction between the second direction and the third direction.
2. The three-dimensional semiconductor memory device of clause 1, wherein the fourth direction forms an acute angle with the second direction.
3. The three-dimensional semiconductor memory device of clause 1 or clause 2, wherein the second region of the active pattern comprises at least one of a first channel region at least partially vertically overlapping the first gate pattern or a second channel region at least partially vertically overlapping the second gate pattern.
4. The three-dimensional semiconductor memory device of any preceding clause, wherein the second region of the active pattern comprises a first channel region at least partially vertically overlapping the first gate pattern, and
   wherein a length of the first channel region is greater than a width of the first gate pattern, along the third direction.
5. The three-dimensional semiconductor memory device of any preceding clause, wherein the first region of the active pattern at least partially vertically overlaps the second gate pattern, and
   wherein the second region of the active pattern at least partially vertically overlaps the first gate pattern.
6. The three-dimensional semiconductor memory device of any preceding clause, wherein the active pattern comprises:
   a first channel region at least partially vertically overlapping the first gate pattern; and
   a second channel region at least partially vertically overlapping the second gate pattern, and
   wherein the second region of the active pattern is interposed between the first channel region and the second channel region of the active pattern.
7. The three-dimensional semiconductor memory device of clause 6, wherein a length of the second region of the active pattern is greater than a distance between the first gate pattern and the second gate pattern.
8. The three-dimensional semiconductor memory device of clause 6 or clause 7, further comprising:
   a bit line conductive line coupling the bit line with the second region of the active pattern.
9. The three-dimensional semiconductor memory device of any preceding clause, wherein the first gate pattern has a greater width than the second gate pattern, along the third direction.
10. The three-dimensional semiconductor memory device of any preceding clause, wherein the second direction and the third direction are perpendicular to each other.
11. A three-dimensional semiconductor memory device, comprising:
   a peripheral circuit structure on a substrate and comprising a page buffer; and
   a cell array structure on the peripheral circuit structure and comprising a stack structure comprising:
      interlayer insulating layers and gate electrodes alternately stacked along a first direction vertical to an upper surface of the substrate; and
      a bit line coupled with the page buffer,
   wherein the page buffer comprises an active pattern, a first gate pattern, and a second gate pattern,
   wherein the first gate pattern and the second gate pattern cross the active pattern in a second direction parallel to the upper surface of the substrate,
   wherein the first gate pattern and the second gate pattern are spaced apart from each other in a third direction crossing the second direction,
   wherein the active pattern comprises:
      a first channel region at least partially vertically overlapping the first gate pattern;
      a second channel region at least partially vertically overlapping the second gate pattern;
      a first contact region and a second contact region spaced apart from each other with the first channel region therebetween; and
      a third contact region spaced apart from the first contact region with the second channel region therebetween,
   wherein the first channel region, the second channel region, and at least one of the first contact region, the second contact region, or the third contact region extend along the third direction, and
   wherein another region of the at least one of the first contact region, the second contact region, or the third contact region extends along a fourth direction between the second direction and the third direction.
12. The three-dimensional semiconductor memory device of clause 11, wherein the fourth direction forms an acute angle with the second direction.
13. The three-dimensional semiconductor memory device of clause 11 or clause 12, wherein the first channel region extends along the fourth direction, and
   wherein a length of the first channel region is greater than a width of the first gate pattern, along the third direction.
14. The three-dimensional semiconductor memory device of any of clauses 11 to 13, wherein the second channel region extends along the fourth direction, and
   wherein a length of the second channel region is greater than a width of the second gate pattern, along the third direction.
15. The three-dimensional semiconductor memory device of any of clauses 11 to 14, wherein the first contact region extends along the fourth direction, and
   wherein a length of the first contact region is greater than a distance between the first gate pattern and the second gate pattern.
16. The three-dimensional semiconductor memory device of clause 15, further comprising:
   a bit line conductive line coupling the first contact region with the bit line.
17. The three-dimensional semiconductor memory device of any of clauses 11 to 16, wherein the second direction and the third direction are perpendicular to each other.
18. The three-dimensional semiconductor memory device of any of clauses 11 to 17, wherein the first gate pattern has a greater width than the second gate pattern, along the third direction.
19. An electronic system, comprising:
   a three-dimensional semiconductor memory device; and
   a controller electrically coupled with the three-dimensional semiconductor memory device through an input-output pad, and configured to control the three-dimensional semiconductor memory device,
   wherein the three-dimensional semiconductor memory device comprises:
      a peripheral circuit structure on a substrate and comprising a page buffer; and
      a cell array structure on the peripheral circuit structure and comprising a stack structure comprising:
         interlayer insulating layers and gate electrodes alternately stacked along a first direction vertical to an upper surface of the substrate; and
         a bit line coupled with the page buffer,
   wherein the page buffer comprises an active pattern, a first gate pattern, and a second gate pattern,
   wherein the first gate pattern and the second gate pattern cross the active pattern in a second direction parallel to the upper surface of the substrate,
   wherein the first gate pattern and the second gate pattern are spaced apart from each other in a third direction crossing the second direction, and
   wherein the active pattern comprises:
      a first region extending along the third direction; and
      a second region extending along a fourth direction between the second direction and the third direction.
20. The electronic system of clause 19, wherein the fourth direction forms an acute angle with the second direction.

## Claims

1. A three-dimensional semiconductor memory device, comprising:
a peripheral circuit structure (PS) on a substrate (10) and comprising a page buffer (4); and
a cell array structure (CS) on the peripheral circuit structure (PS) and comprising a stack structure comprising:
interlayer insulating layers (ILD) and gate electrodes (GE) alternately stacked along a first direction (D1) vertical to an upper surface of the substrate (10); and
a bit line (BL) coupled with the page buffer (4),
wherein the page buffer (4) comprises an active pattern (ACT), a first gate pattern (GT1), and a second gate pattern (GT2),
wherein the first gate pattern (GT1) and the second gate pattern (GT2) cross the active pattern (ACT) in a second direction (D2) parallel to the upper surface of the substrate (10),
wherein the first gate pattern (GT1) and the second gate pattern (GT2) are spaced apart from each other in a third direction (D3) crossing the second direction (D2), and
wherein the active pattern (ACT) comprises:
a first region (R1) extending along the third direction (D3); and
a second region (R2) extending along a fourth direction (D4) between the second direction (D2) and the third direction (D3).

2. The three-dimensional semiconductor memory device of claim 1, wherein the fourth direction (D4) forms an acute angle with the second direction (D2).

3. The three-dimensional semiconductor memory device of claim 1 or claim 2, wherein the second region (R2) of the active pattern (ACT) comprises at least one of a first channel region (CH1) at least partially vertically overlapping the first gate pattern (GT1) or a second channel region (CH2) at least partially vertically overlapping the second gate pattern (GT2).

4. The three-dimensional semiconductor memory device of any preceding claim, wherein the second region (R2) of the active pattern (ACT) comprises a first channel region (CH1) at least partially vertically overlapping the first gate pattern (GT1), and
wherein a length (L1, L3) of the first channel region is greater than a width (W1, W3) of the first gate pattern (GT1), along the third direction (D3).

5. The three-dimensional semiconductor memory device of any preceding claim, wherein the first region (R1) of the active pattern (ACT) at least partially vertically overlaps the second gate pattern (GT2), and
wherein the second region (R2) of the active pattern (ACT) at least partially vertically overlaps the first gate pattern (GT1).

6. The three-dimensional semiconductor memory device of any preceding claim, wherein the active pattern (ACT) comprises:
a first channel region (CH1) at least partially vertically overlapping the first gate pattern (GT1); and
a second channel region (CH2) at least partially vertically overlapping the second gate pattern (GT2), and
wherein the second region (R2) of the active pattern is interposed between the first channel region (CH1) and the second channel region (CH2) of the active pattern (ACT).

7. The three-dimensional semiconductor memory device of claim 6, wherein a length of the second region (R2) of the active pattern (ACT) is greater than a distance between the first gate pattern (GT1) and the second gate pattern (GT2).

8. The three-dimensional semiconductor memory device of claim 6 or claim 7, further comprising:
a bit line conductive line (BCL) coupling the bit line (CL) with the second region (R2) of the active pattern (ACT).

9. The three-dimensional semiconductor memory device of any preceding claim, wherein the first gate pattern (GT1) has a greater width (W1, W3) than the second gate pattern (GT2, W2, W3), along the third direction (D3).

10. The three-dimensional semiconductor memory device of any preceding claim, wherein the second direction (D2) and the third direction (D3) are perpendicular to each other.
